# EUROPEAN PATENT APPLICATION

(11) **EP 3 255 676 A1**
(43) Date of publication of application: **13.12.2017**
(21) Application number: 16173688.9
(22) Date of filing: 09.06.2016
(51) Int. Cl.: H01L 29/06, H01L 29/73

(54) **VERTICAL POWER SEMICONDUCTOR DEVICE AND METHOD FOR OPERATING SUCH A DEVICE**

(71) Applicant: ABB Schweiz AG, 5400 Baden (CH)
(72) Inventor: Knoll, Lars, 5415 Nussbaumen (CH); Minamisawa, Renato, 5210 Windisch (CH)
(74) Representative: ABB Patent Attorneys

(57) **Abstract**

A vertical wide bandgap power semiconductor device comprises from a source side (20) to a drain side (30) a cell (6) having
a source electrode (2), a lowly n- doped drift layer (4), wherein the source electrode (2) forms a Schottky contact to the drift layer (4), a higher doped drain sided layer (5, 55) and a drain electrode (3) formed as an ohmic contact.

A gate electrode (7) is arranged on the source side (20) and comprises an electrically conductive gate layer (70) and an insulating layer (72), which insulates the gate layer (70) from the source electrode (2) and the drift layer (4). The insulating layer (72), the source electrode (2) and the drift layer (4) attach each other at an edge (74). A thickness (76) of the insulating layer (72) at the edge (74) is chosen such that a maximum electric field at the maximum rated voltage is below 5 MeV/cm in the device.

## Description

### Technical Field

The invention relates to the field of power electronics and more particularly to a method for manufacturing a semiconductor device and to such a semiconductor device.

### Background Art

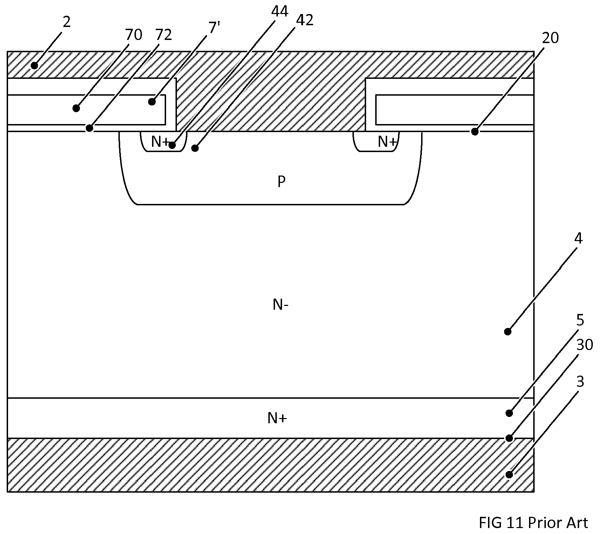

FIG 11 shows a prior art silicon carbide vertical MOSFET, which comprises a MOS cell between a source side 20 and a drain side 30 with an n doped drain layer 5, an n-doped drift layer 4, a p doped channel layer 42 and two n+ doped source layers 44. On the source side 20 two planar gate electrodes 7' are arranged, each of which comprises a gate layer 70 and an insulating layer 72, which insulates the gate layer 70 from the layers 4, 42, 44 of the MOS cell shown in FIG 11, wherein an area between the two gate electrodes 7' defines a source opening. At the source opening a source electrode 2, which electrically forms an ohmic contact to the channel layer 42 and the source layers 44.

Most prior art MOSFETs are based on a planar design, in which a planar gate electrode 7' is formed on top of the drift layer 4 and the source layers 44, wherein the gate layer 70 is insulated from these layers by an insulating layer 72. A channel is formed just below the surface of the wafer. Current densities in such switches are difficult to increase since a junction-FET (JFET) effect occurs between two cells. The JFET-resistance increases with down-scaling of the cells, i.e. with downscaling of the injectors, which increase due to overlapping of the charges from the neighboured cells.

Therefore, MOSFETs have been introduced, which have a trench planar structure, i.e. a trench gate electrode etched into the wafer with a planar gate layer extending to the lateral sides of the trench gate layer. Such prior art devices have lower ON-resistances because of the lack of a JFET region. However, such devices require a highly doped n+ source layer, as well as a p+ contact to the drain electrode to ground the p channel and enable the reverse body diode conduction. Exemplarily, those doped regions, i.e. source layers and drain layer are formed by implantation and activation, which are limited in dimensions due to lithography accuracy and require a huge thermal budget at about > 1600 °C for > 30 min. High thermal budgets tend to degrade the SiC crystal quality and MOS interface, which results mainly in poor carrier mobility and sub-threshold slope. The formation of implantation free prior art vertical power MOSFETs based on in-situ doped epi-layers is difficult as it requires precise lithography and etching. Moreover, the protection of the gate electrode becomes critical as on the one hand the gate electrode has to fully overlap the source layer with a thin (e.g. 50 nm) gate oxide to ensure the channel inversion, but on the other hand need to be protected from high fields in the drift layer with a thick oxide or a highly doped p+ layer.

### Disclosure of Invention

It is an object of the invention to provide a vertical power semiconductor device with improved electrical properties, which can be designed with a high cell density, and which can be manufactured without the need of high temperature processes.

In the inventive device, the source electrode is formed as a Schottky electrode. It acts as a Schottky barrier tunneling source layer, which is connected via a channel of the first conductivity type to the drift layer and a drain sided layer.

The source layer is formed as a Schottky barrier layer, which is reversely biased during operation, to the drift layer. The Schottky barrier layer protects the device from electron injection at zero gate bias. Thus, in contrast to a prior art MOSFET design, there is no need of a channel layer inversely doped to the drift layer to form a potential barrier.

Carrier injection in the inventive Schottky barrier MOSFET (or IGBT) occurs at high fields at the edge between the gate electrode, Schottky layer and drift layer. The following shall refer to MOSFETs, but shall also be applicable to IGBTs. At high reverse voltages at the gate electrode the electrostatic field of the gate electrode induces an electron tunneling from the source electrode (Schottky metal) through a thin potential barrier. The tunneling current depends on the thickness of the insulating layer of the gate electrode at the edge and the applied gate voltage.

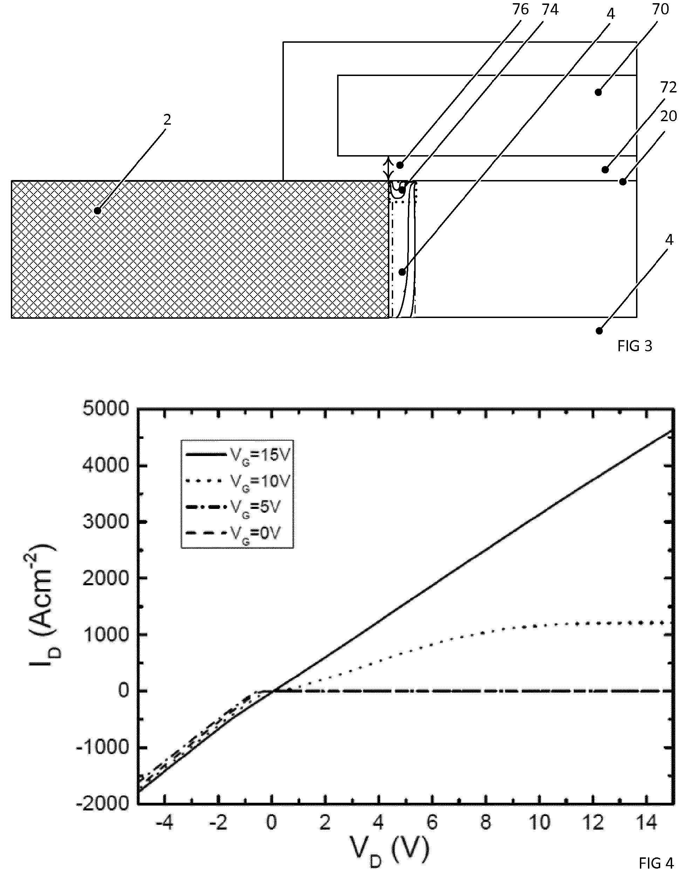

FIG 3 shows the electron barrier tunneling at the edge between source electrode, gate electrode and drift layer for V_{Gate} =V_{drain} = 15 V, a Schottky barrier height of 0.9 eV and an oxide thickness of 20 nm. In the drift layer below the gate electrode and along the edge between source electrode and drift layer, i.e. downwards in direction of the drain electrode (shown in FIG 3 by the dotted-dashed region) a small amount of tunneling is observed, since the barrier is reversely biased with the drain voltage. In the example, the high fields in a region of less than 1 nm below the gate electrode (thick dotted region), however, generate significantly larger tunneling rates of about a factor of 1 x 10⁹ cm³ higher than compared to regions with a distance of more than 1 nm from the gate electrode. Thus, carrier injection mainly occurs directly below the gate electrode, other injection can be neglected in the inventive configuration. In FIG 3 some equipotential tunneling generation densities in the tunneling region are shown, the line closest to the source side 20 having the highest current density and the outermost line having a low current density.

FIG 4 shows the output (I_{drain}-V_{drain}) characteristics of an inventive 1.7 kV trench Schottky barrier MOSFET with a drift layer thickness of 15 µm, a doping level of 4 x 10¹⁵cm⁻³ and a Schottky barrier height of 0.9 eV. For V_{Gate} = 0 V and V_{Drain} < 0 V, the device conducts with an opening voltage of about - 0.9 V. In forward polarity the device is closed due to the large Schottky barrier and no tunneling injection. In this configuration the device behaves similar to a prior art Schottky barrier diode. Applying a positive gate voltage switches the device into the on-state. At V_{Gate} = + 15 V, the device is fully on and almost linear. I_{drain} - V_{drain} characteristic is observed for ranging V_{Gate} from - 5 V to + 15 V. A slightly larger resistance is observed for V_{Gate} > 0 V, i.e. a sloped characteristics, due to the localized tunneling carrier injection. The overall conduction current density in forward direction, however, is very large. In forward direction the resistance is reduced in the inventive device as described above by only 18 %, compared to a prior art reverse diode. Compared to the simulation of conventional MOSFETS in FIG 11, the forward voltage loss is significantly reduced. At V_{Gate} = + 10 V or larger gate voltages the inventive Schottky barrier MOSFET shows an "S-shape" in the output, typical for tunneling devices.

The inventive semiconductor devices achieve for reverse leakage and blocking capability no degradation compared to prior art Schottky barrier diodes.

Under reverse bias, the Schottky contact works as the antiparallel freewheeling diode. Prior art hybrid devices have been fabricated with separated MOSFET and Schottky diode cells in the active area, with the disadvantage that conduction is lost and thereby high on-state losses are created. However, in unipolar devices such as MOSFETs this is a critical feature. For inventive semiconductor devices, both MOSFET and diode are included in the same cell, thereby increasing significantly the cell density. The on-state current density is higher than for prior art devices due to the absence of channel inversion. Furthermore, the built-in internal anti-parallel freewheeling Schottky diode has an opening voltage which is lower than its bipolar body diode counterpart in the prior art MOSFETs.

Thus, the chip area can be used optimally with the inventive design, with MOSFET and diode in the same cell. Therefore, space between the cells can be miniaturized which leads to better input capacitance and consequently also to an improvement for the switching speed of the device. The high cell density and therefore high channel density allows for a better current spreading.

The conduction starts in the channel in the edge below the gate electrode as described above. Once the carriers are injected into the channel, the current spreads within the entire area between two neighboured gate electrodes. In prior art MOSFET designs the inverse doping of the p channel layer (well layer) and drift layer avoids such a current sharing. The current sharing capability of the inventive design enables a large forward conduction. Additionally, in the inventive device, short channel effects are suppressed due to enhanced gate electrostatic control at the tunneling junction.

Compared to prior art Schottky MOSFETs an ambipolar behavior is suppressed due to the drain ohmic contact.

In prior art devices, high activation annealing temperature is needed for activating the n source layer and the p channel layer. However, the high thermal budget degenerates the Si or wide bandgap crystal such as SiC crystal and thus reduces the inversion channel mobility. The inventive design does not require an activation anneal, which results in higher carrier mobility than for prior art devices. Furthermore, the manufacturing of inventive devices without the need to perform implantation processes reduces costs and improves the semiconductor material interface to the gate electrodes (e.g. Si/wide bandgap material such as SiC as semiconductor material) and an oxide layer as insulating layer of the gate electrode.

Further preferred embodiments of the inventive subject matter are disclosed in the dependent claims.

### Brief Description of Drawings

The subject matter of the invention will be explained in more detail in the following text with reference to the attached drawings, in which:
- FIG 1: shows a cell of an inventive trench gate power MOSFET;
- FIG 2: shows a cell of an inventive planar gate power MOSFET;
- FIG 3: shows a detail of FIG 2;
- FIG 4: the output (I_{drain}-V_{drain}) characteristics of an inventive MOSFET;
- FIG 5: shows an inventive MOSFET with two MOS cells;
- FIG 6: shows an inventive MOSFET with super-junction layers;
- FIG 7: shows an inventive MOSFET with semi super-junction layers;
- FIG 8: shows an inventive MOSFET having a shallow, highly doped protection layer;
- FIG 9: shows a cell of an inventive trench gate power IGBT;
- FIG 10: shows a cell of an inventive planar gate power IGBT; and
- FIG 11: a prior art MOSFET.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

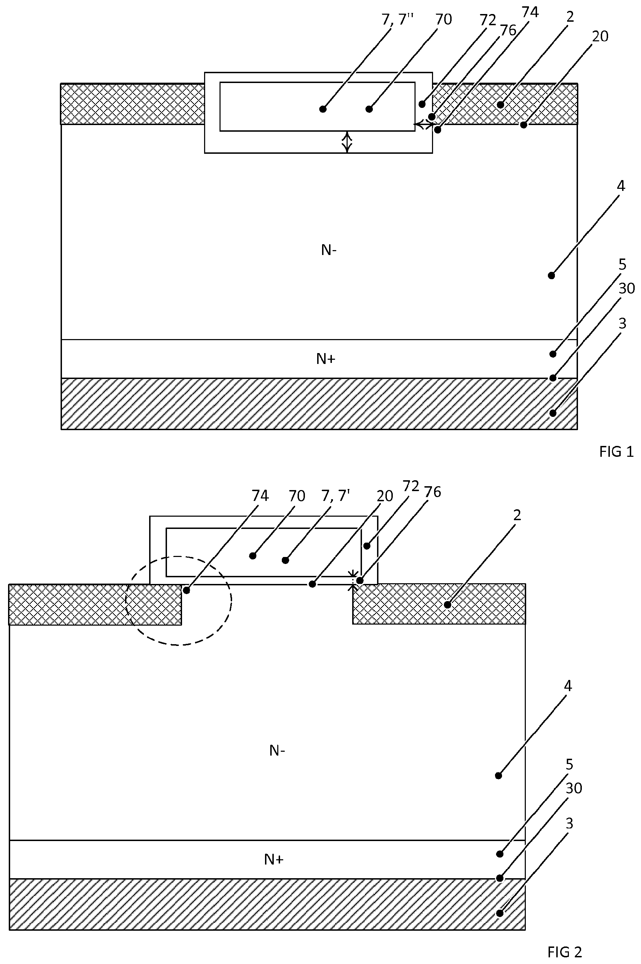

FIG 1 shows an inventive vertical power semiconductor device comprising from a source side 20 to a drain side 30 opposite to the source side 20 an active cell 6. A vertical device is a semiconductor device, in which the source and drain electrode are arranged on opposite sides of the device. The device in FIG 1 is a metal oxide semiconductor field-effect transistor (MOSFET). Each MOS cell 6 comprises a source electrode 2, a lowly doped drift layer 4 of a first conductivity type, which is in the example shown in FIG 1 an n- doped layer, a drain sided layer in form of a drain layer 5 of the first conductivity type, which is higher doped than the drift layer 4, and a drain electrode 3, which contacts the drain layer 5. The cell 6, 6' can either be formed from source electrode 2 to another source electrode (as shown in _FIG 1) or from gate electrode 7 to gate electrode, i.e. shifted from the cell shown in FIG 1 by a half cell. In any case, the cell is formed by two half cells, wherein each half cell comprises one source electrode 2 and one gate electrode 7. If a plurality of cells are arranged in a device, the cell is formed from the center of a gate electrode to another center of a gate electrode (or center form a source electrode to another center of a gate electrode).

In an exemplary embodiment, the doped layers of the device, i.e. the drift layer 4 and the drain layer 5, are wide bandgap layers. Exemplarily, such wide bandgap layers are made of silicon carbide. In an alternative embodiment, the doped layers are silicon layers.

Wide band gap materials shall be materials having a bandgap of at least 2 eV like silicon carbide, gallium nitride or diamond or such a group-III-Nitride (AlGaln) not excluding other wide bandgap materials. Exemplarily, the wide bandgap material is SiC (silicon carbide), exemplarily 3 C, 4 H or 6 H SiC.

Depending on the voltage class, the doping concentration and thickness of the drift layer 4 are chosen. Exemplarily, the drift layer 4 has a doping concentration between 1 x 10¹² and 5 x 10¹⁷ cm⁻³ and a thickness between 3 µm to 250 µm. The thicknesses shall be measured in depth direction, i.e. in a direction vertical to the source side 20.

Exemplarily, the drift layer 4 has a constantly low doping concentration. Therein, the substantially constant doping concentration of the drift layer 4 shall mean that the doping concentration is substantially homogeneous throughout the drift layer 4, however without excluding that fluctuations in the doping concentration within the drift layer being in the order of a factor of one to five.

On the source side 20 of the SiC wafer a source electrode 2 is arranged which forms a Schottky contact to the drift layer 4. The source electrode 2 may have a Schottky barrier height between 0.5 eV to 2 eV or between 0.7 eV to 1.1 eV. The source electrode 2 is a metal layer, such as titanium (Ti), cobalt (Co), tantalum (Ta), tungsten (W), platinum (Pt), nickel (Ni), molybdenum (Mo), palladium (Pd), aluminium or any combination of these metals. The source electrode 2 can also include silicide or carbide compounds, such as Ni_{X}Si_{Y}, TiC, TaC or WC. The source electrode 2 can also be a stack of metal layers, e.g. Al/Ti, Al/Ni, Al/W, Al/Pt, Al/Ni/Ti, Al/Mo, Al/Pd, Al/WC, or Al/TaC, in which a diffusion barrier layer like TaSiN can be formed in between the top Al and the first metal layer.

An ohmic contact is an electrical junction between two conductors (i.e. for a semiconductor between a metal layer and a semiconductor layer, i.e. a doped Silicon-carbide layer) that has a linear current-voltage behavior. An ohmic contact has low resistance. Exemplarily, the ohmic contacts on the drain side form a drain electrode for an inventive MOSFET. By contrast, a Schottky contact is a junction or contact that does not demonstrate a linear I-V curve (so that it is a non-ohmic contact). The Schottky barrier of a Schottky contact between a metal and a semiconductor band defines the device opening voltage in forward bias, i.e., carrier flows when the barrier is overcome.

An n doped drain layer 5 is arranged on the drain side 30, which has a higher doping concentration than the drift layer 4. Exemplarily, the doping concentration of the drain layer 5 is above 1 x 10¹⁸, exemplarily between 5 x 10¹⁸ and 1 x 10²⁰ cm⁻³. The drain layer 5 attaches towards the source side 20 the drift layer 4 and contacts on the drain side 30 a drain electrode 3 formed as an ohmic contact. Exemplarily, the doping concentration of the drain layer 5 is at least a factor of 1000 higher than the doping concentration of the drift layer 4.

A gate electrode 7, 7', 7" is arranged on the source side 20 and comprises an electrically conductive gate layer 70 and an insulating layer 72, which insulates the gate layer 70 from the source electrode 2 and the drift layer 4 (and any other doped layer).

In case of the insulating layer 72 being an oxide layer and the gate layer 70 being made of an electrically conductive material, the inversion-channel is called a MOS channel (metal-oxide/insulator-semiconductor), whereas otherwise (insulating layer 72 being made of any insulating materials; e.g. dielectrics such as high-k materials or silicate glasses such as PSG (phosphorous silicate glass, also called phosphosilicate glass) or BPSG (boron phosphorous silicate glass, also called borophosphosilicate glass), but not excluding other insulators) the channel may also be called MIS channel (metal-insulator-semiconductor).

As a material for the gate layer 70 any appropriate electrically conductive material like a metal or doped polycrystalline silicon may be used. The term MOS device/MOSFET shall also cover such MIS devices/ MISFETs. The inventive MOSFETs shall exemplarily have a rated voltage of at least 100 V or at least 200 V.

The gate electrode 7 may be a planar gate electrode 7', which is arranged on top of the SiC wafer (shown in FIG 2). For a planar gate electrode 7', the insulating layer 72 is arranged on top of the drift layer 4 with an insulating layer thickness between the gate layer 70 and the drift layer 4. Below the gate layer, the insulating layer 72 has a thickness 76 at an edge 74 of insulating layer with the source electrode 2 and the drift layer 4. Exemplarily, this thickness is constant between the gate layer 70 and the drift layer 4.

The gate layer 70 is separated from the drift layer 4 by the insulating layer 72. Exemplarily, the gate layer is embedded in the insulating layer 72, i.e. the insulating layer 72 surrounds the gate layer towards the lower side (i.e. towards the drift layer 4), the lateral sides (i.e. the sides perpendicular to the source side 20) and the top side. In order to achieve a better insulation on the lateral sides and the top side, the insulating layer may have a greater thickness on those side than towards the drift layer 4.

For a planar gate electrode 7', the gate layer 70 has an overlap with the below lying source electrode 2 in vertical direction to the source side 20 (which shall be the outermost plane of the SiC wafer on the side, at which the source electrode 2 is arranged).

The gate electrode 7, 7', 7", i.e. the insulating layer 72, the source electrode 2 and the drift layer 4 attach each other at an edge 74. A thickness 76 of the insulating layer 72 at the edge 74 is chosen such that a maximum electric field at the maximum rated voltage is below 5 MeV/cm in the device. In an exemplary embodiment, the maximum electric field is below 2 MeV/cm. The thickness 76 of the insulating layer 72 at the edge 76 may exemplarily be between 1 to 100 nm or between 10 nm to 100 nm. The thickness 76 of the insulating layer shall be measured as the shortest extension of the insulating layer 72 between the gate layer 70 and the drift layer 4 at the edge 74.

Such a thickness enables the device to have a tunnelling effect of charges at the edge region (as shown in FIG 3 by the high current densities in the drift layer at the edge, i.e. just below the gate electrode 7. Due to the tunneling at the edge 74 a MOS channel may be formed from the source electrode 2 to the drift layer 4 in such a cell 6.

Alternatively to the planar gate electrodes 7', the inventive device may comprise a trench gate electrode 7" (FIG 1), for which a trench has been introduced perpendicular to the source side 20 laterally to the source electrode 2. The trench gate electrode 7" is arranged in the same plane as the source electrode 2, i.e. the trench gate electrode 7" and source electrode 2 alternate and attach each other. In these trenches, the insulating layer 74 covers the walls of the trenches towards the wide band gap layers and separates the gate layer 70, with which the trenches are filled, from the wide bandgap layers. On the source side 20, the insulating layer 72 separates the gate layer 70 from the source electrode 2. The gate layer 70 extends to a greater depth than the source electrode 2 in vertical direction to the source side 20. Again, the insulating layer 72 has a thickness 76 at the edge of the insulating layer 72 with the drift layer 4 and the source electrode 2. For a trench gate electrode 7", the insulating layer 72 may have a larger thickness 78 below the gate layer 70 to achieve a better insulation effect.

The power semiconductor device may comprise just one MOS cell as shown in FIG 1 or 2, but in an exemplary embodiment, an inventive MOSFET comprises a plurality of cells 6, 6', i.e. two or more cells 6, 6'. The cells 6, 6' may be formed by lateral repetition of the cell 6 as exemplarily shown in FIG 1 or 2. Such cells 6 may be arranged receptively to the lateral sides of the MOS cell 6, i.e. the source electrode 2 may be continued to form also a source electrode 2 of a neighboured MOS cell 6. The right source electrode of the left handed cell 6 forms a continuous source electrode 2 with the left source electrode 2 of the right handed cell 6', so that the two source electrodes 2 of neighboured cells facing each other form a common source electrode 2. The cells 6, 6', i.e. the regions in the cells, may be designed to form of regular patterns like stripes, hexagonal, triangular or square design. Such MOS cells may be interconnected to each other.

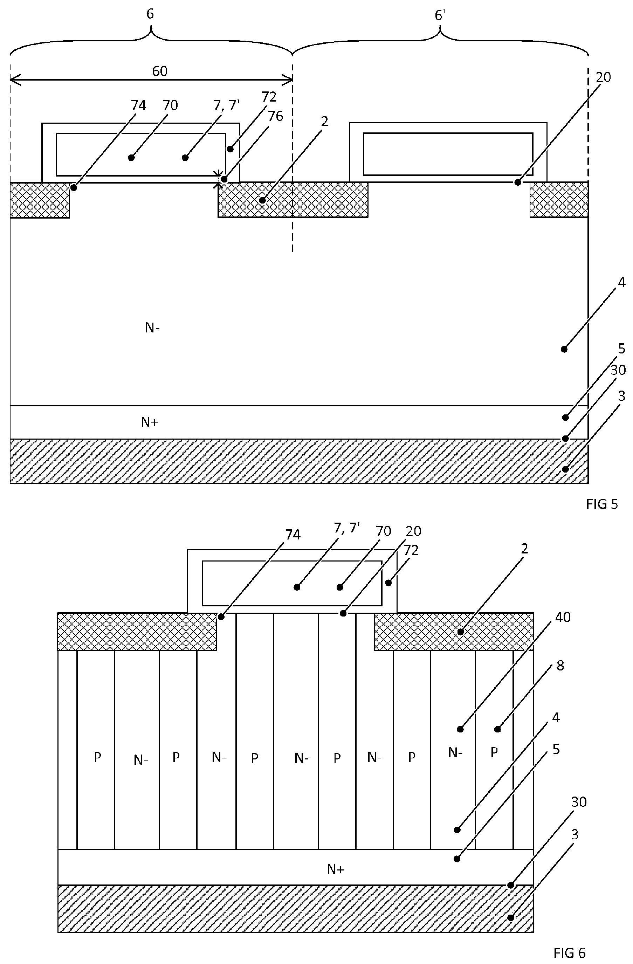

FIG 5 shows exemplarily an inventive MOSFET with two cells 6, 6'. In the case of a plurality of cells 6, 6', two neighboured cells 6, 6' may have a cell pitch 60 (width of the cell) of at least 20 nm or of at most 20 µm or between 20 nm to 20 µm.

In another exemplary embodiment, the device comprises in a direction perpendicular to the source side 20 the drift layer 4 comprising a plurality of regions 40 of the first conductivity type (i.e. n- doped in case of the drift layer being of the n doping type) and a plurality of regions 8 of the second conductivity type (i.e. p doping type in the present example). The n- and p doped regions 40, 8 alternate in a plane parallel to the source side 20. As shown in FIG 6 these regions extend from the source side 20 (below the gate electrode 7, 7', 7" and the source electrode 2) to the drain sided layer 5 (or the collector layer 55 in case of a NPT-IGBT or the buffer layer 46 in case of a PT-IGBT), i.e. they are in touch with the drain layer 5, by which arrangement a super-junction device is formed. The n doped regions 40 are arranged at the edges 74 of the gate electrode 7, 7', 7" and the p doped regions 8 are arranged at lateral sides (i.e. lateral in a plane parallel to the source side 20) and therefore, to the n doped regions 40 at the edge 74.

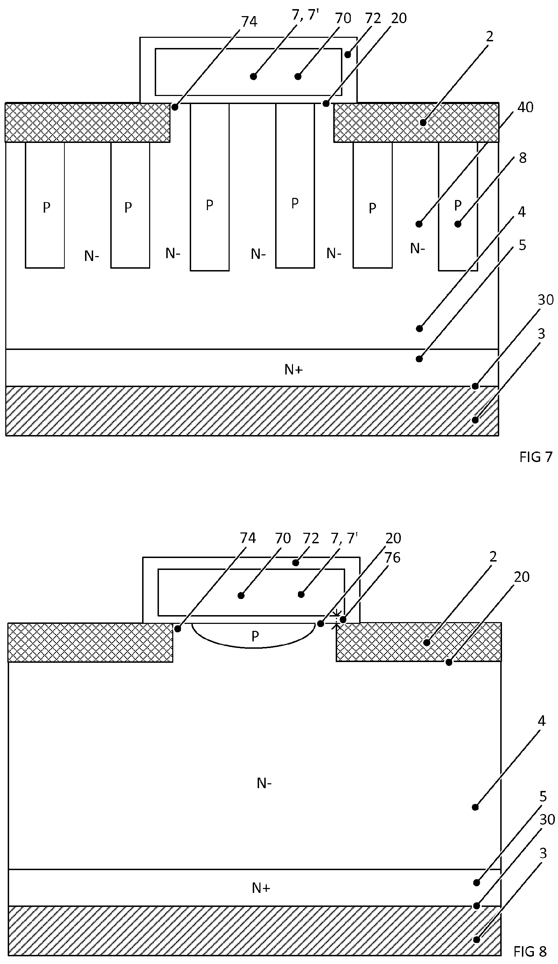

In an alternative embodiment, the p doped regions 8 extend to an area within the drift layer 4, so that the drift layer 4 separates the p doped regions 8 from the drain layer 5 (FIG 7). For an inventive IGBT described below, the drift layer 4 separates the p doped regions 8 from the drain sided layer, the collector layer in case of a NPT-IGBT or the buffer layer 46 in case of a PT-IGBT. On the source side 20, the p doped regions 8 extend to the source electrode 2 and the gate electrode 7.

In another alternative embodiment, a p doped protection layer 9 may be arranged below the gate electrode 7, 7', 7" and in contact to it, i.e. in contact to the insulating layer 72. The maximum doping concentration of the protection layer may be at least 1 x 10¹⁸ cm⁻³.

An inventive MOSFET may be operated by applying a positive voltage at the gate layer such that enabling a tunnelling of electrons from the source electrode to the drift layer in an area directly below the gate electrode. By applying the positive voltage at the gate layer a maximum electric field at the maximum rated voltage is kept below 5 MeV/cm in the device. Exemplarily, the voltage at the gate layer is at least + 10 V.

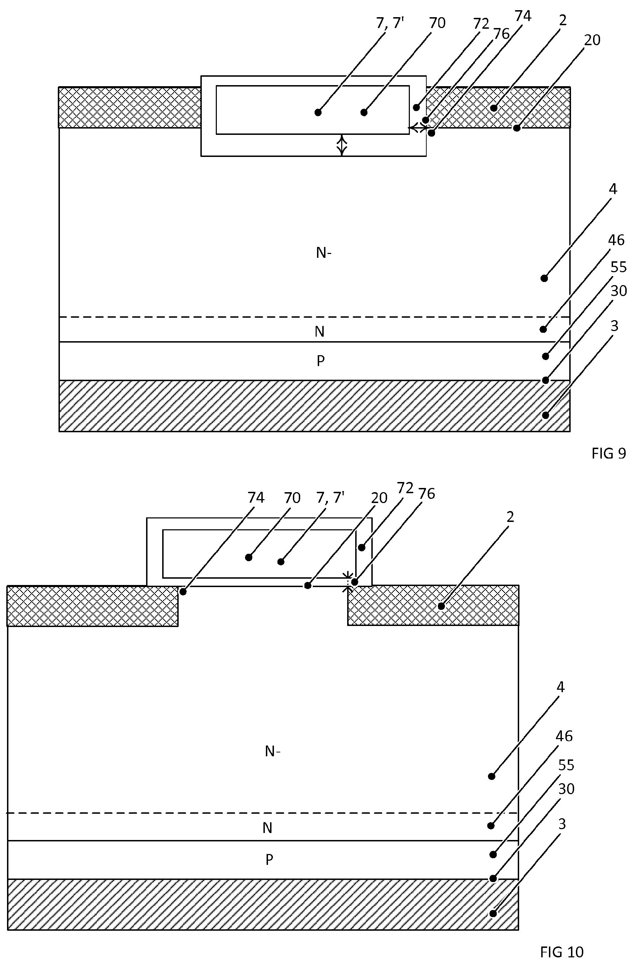

On the drain side 30, a drain sided layer 5, 55 is arranged, which is in the case of the inventive device being a MOSFET an n doped drain layer 5. In another embodiment, the inventive cell 6, 6' is integrated into an inventive insulated gate bipolar transistor (IGBT), for which on the drain side 30 a p doped collector layer 55 is arranged as drain sided layer instead of the n doped drain layer for the MOSFET. FIG 9 shows exemplarily a non-punch through IGBT with trench gate electrode 7" and FIG 10 a non-punch through IGBT with planar gate electrode 7'.

The inventive cell 6, 6' can be applied to a non punch-through IGBT, which comprises on the drain side 30 a p doped collector layer 55, which has exemplarily has exemplarily a doping concentration between 1 * 10¹⁸ and 1 * 10²⁰ cm⁻³. The collector layer 55 contacts the drain electrode 3 (which may also be called collector electrode in an IGBT) as an ohmic contact. For a non punch-through IGBT, the collector layer 55 contacts towards the source side 20 the drift layer 4. The source electrode 2 may also be called emitter electrode for an IGBT.

The inventive cell 6, 6' may also be applied to a punch-through IGBT (i.e. an IGBT with a buffer layer 46, which additionally comprises between the drift layer 4 and the collector layer 55 an n doped buffer layer 46, which has a higher doping concentration than the drift layer 4). In the figures 9 and 10 the buffer layer 46 is drawn by a dashed line, thereby indicating that this layer is an optional layer, which is present in a punch-through IGBT, but omitted in a non punch-through IGBT.

The buffer layer 46 may have an exemplary doping concentration between 1 * 10¹⁷ and 1 * 10¹⁸ cm⁻³ and a thickness up to 3 µm. In case of the non-punch through design the E-field is triangular in shape up to avalanche breakdown. In the other case the E-field penetrates through the interface between drift layer 4 and buffer layer 46 where it gets stopped due to the high doping concentration of the buffer layer 46.

In a further exemplary embodiment, the inventive cell 6, 6' may be applied to a reverse-conducting IGBT, which comprises additionally to the non punch-through IGBT or punch-through IGBT an n doped cathode layer, which comprises a plurality of cathode regions. The collector layer 55 also comprises a plurality of collector regions 55. The cathode layer is higher doped than the drift layer 4, and, if a buffer layer 46 is arranged between drift and collector layer 4, 55, the cathode layer has also higher doping concentration than the buffer layer 46. Cathode and collector regions are arranged alternatingly on the drain side 30 and contact the collector electrode 3.

Exemplarily, an inventive reverse-conducting IGBT is formed as a Bi-mode Insulated Gate Transistor (BIGT) additionally having a large pilot p+ collector layer in the central part of the device on the drain side 30 surrounded by alternating smaller p+ collector regions and n+ cathode regions. Such BIGTs are disclosed in US 8 212 283 B2, which document shall be incorporated by reference for the design of a BIGT.

All designs are explained and shown in the figures 1 to 8 for an inventive MOSFET, but are also applicable to an IGBT (of a non-punch through or punch-through as well as reverse-conducting type), whereas FIG 9 shows exemplarily.

The values for the doping concentration given above shall be understood as the mean doping concentration for the exemplarily constant doping concentration of the layers (not excluding variation of doping concentration due to imperfection of the manufacturing method).

In another embodiment, the conductivity types of the layers are switched, i.e. all layers of the first conductivity type are p type (e.g. the drift layer 4 and the drain layer 5) and all layers of the second conductivity type are n type (e.g. region of the second conductivity type and the protection layer 9).

### List of reference signs

- 1: vertical MOSFET
- 2: source electrode
- 20: source side
- 3: drain electrode
- 30: drain side
- 4: drift layer
- 40: region of the first conductivity type
- 42: channel layer
- 44: source layer
- 46: buffer layer
- 5: drain layer
- 50: part of the drain layer
- 55: collector layer
- 6,6': cell
- 60: cell pitch
- 7: gate electrode
- 7': planar gate electrode
- 7": trench gate electrode
- 70: gate layer
- 72: insulating layer
- 74: edge
- 76: thickness at edge
- 8: region of the second conductivity type
- 9: protection layer

## Claims

1. A vertical power semiconductor device comprising from a source side (20) to a drain side (30) opposite to the source side (20) a cell (6, 6') having a source electrode (2),
a lowly doped drift layer (4) of a first conductivity type, wherein the source electrode (2) forms a Schottky contact to the drift layer (4), and
a drain sided layer (5, 55), which is higher doped than the drift layer (4), a drain electrode (3) formed as an ohmic contact to the drain sided layer (5, 55), wherein a gate electrode (7, 7', 7") is arranged on the source side (20) and comprises an electrically conductive gate layer (70) and an insulating layer (72), which insulates the gate layer (70) from the source electrode (2) and the drift layer (4),
wherein the insulating layer (72), the source electrode (2) and the drift layer (4) attach each other at an edge (74), and wherein
a thickness (76) of the insulating layer (72) at the edge (74) is chosen such that a maximum electric field at the maximum rated voltage is below 5 MeV/cm in the device.

2. The device according to claim 1, **characterized in, that** the maximum electric field is below 2 MeV/cm.

3. The device according to one of the claims 1 or 2, **characterized in, that** the drift layer (4) and the drain sided layer (5, 55) are wide bandgap layers.

4. The device according to one of the claims 1 or 2, **characterized in, that** the drift layer (4) and the drain sided layer (5, 55) are silicon carbide layers.

5. The device according to one of the claims 1 or 2, **characterized in, that** the drift layer (4) and the drain sided layer (5, 55) are silicon layers.

6. The device according to one of the claims 1 to 5, **characterized in, that** the thickness (76) of the insulating layer (72) at the edge (76) is between 1 to 100 nm or between 10 to 100 nm.

7. The device according to one of the claims 1 to 6, **characterized in, that** the device comprises at least two cells (6, 6'), wherein two neighboured cells (6, 6') have a cell pitch (60) of at least 20 nm or of at most 20 µm or between 20 nm to 20 µm.

8. The device according to one of the claims 1 to 7, **characterized in, that** the drift layer comprises a plurality of regions (40) of the first conductivity type extending from the source side (20) towards the drain side (30), and in a direction parallel to the source side (20) the device comprises a plurality of regions of the second conductivity type (8) extending from the source side (20) to a region within the drift layer (4), so that the drift layer (4) separates the plurality of regions of the second conductivity type (8) from the drain sided layer (5, 55),
wherein the regions of the first conductivity type alternate with the regions (8) of the second conductivity type and wherein at each edge (74) a region (40) of the first conductivity type is arranged.

9. The device according to one of the claims 1 to 7, **characterized in, that** the drift layer comprises a plurality of regions (40) of the first conductivity type extending from the source side (20) towards the drain side (30), and in a direction parallel to the source side (20) the device comprises a plurality of regions of the second conductivity type (8) extending from the source side (20) to the drain sided layer (5, 55), wherein the regions of the first conductivity type alternate with the regions (8) of the second conductivity type and wherein at each edge (74) a region (40) of the first conductivity type is arranged.

10. The device according to one of the claims 1 to 9, **characterized in, that** below the gate electrode (7, 7', 7") a protection layer (9) of the second conductivity type is arranged, which contacts the insulating layer (72), which protection layer (9) has a maximum doping concentration of at least 1 x 10¹⁸ cm⁻³.

11. The device according to one of the claims 1 to 10, **characterized in, that** the source electrode (2) has a Schottky barrier height between 0.5 to 2 eV or between 0.7 to 1.1 eV.

12. The device according to one of the claims 1 to 11, **characterized in, that** the gate electrode (7) is a planar gate electrode (7') and **in that** the insulating layer (72) has a greater thickness below the gate layer (70) than at the edge (74) of the insulating layer (72), the source electrode (2) and the drift layer (4).

13. The device according to one of the claims 1 to 12, **characterized in, that** the source electrode (2) is made of Titanium, Wolfram, Nickel, Cobalt, Aluminium, Titanium carbide, wolfram carbide or Nickel silicide.

14. A method for operating a vertical power semiconductor device according to any of the claims 1 to 13, **characterized in, that** applying a positive voltage at the gate layer (70) such that enabling a tunnelling of charges from the source electrode (2) to the drift layer (4) in an area directly below the gate electrode (7, 7', 7").

15. The method according to claim 14, **characterized in, that** a voltage at the gate layer (70) of at least + 10 V.
